# EUROPÄISCHE PATENTSCHRIFT

(11) **EP 3 602 781 B1**
(45) Veröffentlichungstag und Bekanntmachung des Hinweises auf die Patenterteilung: **12.04.2023**
(21) Anmeldenummer: 18706243.5
(22) Anmeldetag: 15.02.2018
(51) Int. Cl.: H03K 3/353, H03K 3/36, G05B 19/10

(54) **KONFIGURATIONSSCHALTER SOWIE BUSTEILNEHMER MIT EINEM SOLCHEN KONFIGURATIONSSCHALTER**
CONFIGURATION SWITCH AND BUS PARTICIPANT WITH SUCH A CONFIGURATION SWITCH
SÉLECTEUR DE CONFIGURATION ET UTILISATEUR DE BUS AVEC UN TEL SÉLECTEUR DE CONFIGURATION

(30) Priorität: 24.03.2017 DE 102017106400
(43) Veröffentlichungstag der Anmeldung: 05.02.2020
(73) Patentinhaber: Endress+Hauser SE+Co. KG, 79689 Maulburg (DE)
(72) Erfinder: SCHÄUBLE, Harald, 79541 Lörrach (DE); PAUL, Tobias, 79650 Schopfheim (DE); GERWIG, Simon, 79650 Schopfheim (DE); BAUER, Max, 79618 Rheinfelden (DE)
(74) Vertreter: Laufer, Michael
(86) Internationale Anmeldenummer: PCT/EP2018/053793
(87) Internationale Veröffentlichungsnummer: WO 2018/171984

(56) Entgegenhaltungen:
- EP-A1- 3 021 090
- WO-A1-82/03477
- WO-A1-82/03477
- DE-A1- 4 118 702

## Beschreibung

Die Erfindung bezieht sich auf einen Busteilnehmer mit einem Konfigurationsschalter zur Einstellung einer spezifischen Konfiguration aus einer Vielzahl von einstellbaren Konfigurationen.

Konfigurationsschalter dienen ganz allgemein dazu, an einem Gerät, bspw. einem Feldgerät der Automatisierungstechnik, eine spezifische Konfiguration aus einer Vielzahl von möglichen einstellbaren Konfigurationen durch einen Bediener einzustellen.

Feldgeräte dienen zur Erfassung von Prozessgrößen, wie beispielsweise Füllstandsmessgeräte, Durchflussmessgeräte, Druck- und Temperaturmessgeräte, pH-Messgeräte, Leitfähigkeitsmessgeräte, usw., welche die entsprechenden Prozessgrößen Füllstand, Durchfluss, Druck, Temperatur, pH-Wert bzw. Leitfähigkeit erfassen. Zur Beeinflussung der Prozessgrößen werden Aktoren verwendet, wie Ventile oder Pumpen, über die z.B. der Durchfluss einer Flüssigkeit in einer Rohrleitung oder der Füllstand eines Mediums in einem Behälter geändert wird. Als Feldgeräte werden im Prinzip alle Geräte bezeichnet, die prozessnah eingesetzt werden und die prozessrelevante Informationen liefern oder verarbeiten. Eine Vielzahl solcher Feldgeräte wird von der Firmengruppe Endress+Hauser angeboten und vertrieben. Unter dem in Verbindung mit der Erfindung verwendeten Begriff Feldgerät sind somit alle Typen von Messgeräten und Aktoren zu subsumieren. Weiterhin umfasst der Begriff Feldgerät aber auch z.B. ein Gateway, einen Funkadapter oder andere in ein Bussystem integrierte/integrierbare Busteilnehmer.

Konfigurationsschalter können bei Feldgeräten bspw. in Form von Adressschaltern vorliegen, über die bei dem Feldgerät eine spezifische Adresse eingestellt wird. Aber nicht nur zum Einstellen einer spezifischen Adresse, sondern bspw. auch zum Einstellen eines "High Alarms" oder eines "Low Alarms", werden Konfigurationsschalter verwendet.

Kurzum, Konfigurationsschalter kommen überall da zum Einsatz, wo ein Bediener ein Gerät auf eine spezifische Konfiguration einstellen muss. Um eine spezifische Anzahl an unterschiedlichen Konfigurationen einstellen zu können, benötigen Konfigurationsschalter für gewöhnlich so viele Leitungen, wie im binären Zahlensystem der Wertigkeit entspricht. Beispielsweise benötigt ein Konfigurationsschalter 7 Leitungen um durch ihn 2^7 (zwei hoch sieben) = 128 unterschiedliche Konfigurationen einstellen zu können. Zusätzlich benötigt der Konfigurationsschalter eine Hardware- und/oder eine Software-Umschaltungen mittels derer der Bediener eine (einzige) spezifische Konfiguration auswählen kann. Typischerweise werden dazu I2C - I/O-Expander verwendet. Falls keine I2C Ports zur Verfügung stehen, oder nur noch ein einziger Pin, kann dies nur mit einem zusätzlichen Prozessor gelöst werden. Der zusätzliche Prozessor benötigt jedoch einen erhöhten Platzbedarf auf der Elektronikplatine und sorgt für zusätzliche Kosten.

Aus dem Stand der Technik sind WO 82/03477 A1, DE 41 18 702 A1 sowie die EP 3 021 090 A1 bekannt geworden. Die WO 82/03477 A1 bezieht sich auf das Gebiet der Frequenzsynthesizer, insbesondere zur Verwendung eines solchen in Kommunikations-Transceivern. Die EP 3 021 090 A1 bezieht sich auf ein Ein- /Ausgabemodul, welches für den Anschluss eines Controllers und eines Feldgerätes konfiguriert ist. Die DE 41 18 702 A1 offenbart einen Busteilnehmer, dessen Konfiguration auf einer festen RC-Kombination basiert.

Es ist somit eine Aufgabe der Erfindung, einen Konfigurationsschalter vorzuschlagen, bei dem eine spezifisch ausgewählte Konfiguration mit nur einer einzigen Leitung bestimmt bzw. ausgelesen werden kann.

Die Aufgabe wird erfindungsgemäß durch einen Busteilnehmer mit einem Konfigurationsschalter zur Einstellung einer spezifischen Konfiguration aus einer Vielzahl von einstellbaren Konfigurationen gelöst, wobei der Konfigurationsschalter zumindest eine Vielzahl von auswählbaren jeweils unterschiedlichen Widerstand-Kapazität-Kombination (im Folgenden: RC-Kombination abgekürzt) aufweist, wobei jede RC-Kombination zumindest eine spezifische charakteristische Größe aufweist, die einer einstellbaren Konfiguration zugeordnet ist und wobei zum Einstellen der spezifischen Konfiguration eine spezifische RC-Kombination ausgewählt wird/auswählbar ist, so dass über ein Ausgangssignal an einem (einzigen) Ausgang des Konfigurationsschalters, welches Ausgangssignal die spezifische charakteristische Größe der ausgewählten RC-Kombination umfasst, die einzustellende spezifische Konfiguration anhand der spezifischen charakteristischen Größe festgelegt ist.

Erfindungsgemäß wird ein Busteilnehmer mit einem Konfigurationsschalter mit mehreren RC-Kombinationen vorgeschlagen, bei dem jede RC-Kombination eine charakteristische Größe aufweist und bei dem der Bediener eine spezifische RC-Kombination auswählen kann, so dass anhand eines Ausgangssignals, welches an einem (einzigen) Ausgang abgreifbar ist, die einzustellende spezifische Konfiguration anhand der ausgewählten spezifischen RC-Kombination und somit der spezifischen charakteristischen Größe für diese RC-Kombination ermittelbar ist.

Eine vorteilhafte Ausgestaltung des Busteilnehmers sieht vor, dass die einzustellende spezifische Konfiguration und/oder die Vielzahl von einstellbaren Konfigurationen eine Adresse eines Busteilnehmers umfassen, insbesondere eine Slaveadresse eines Profibus- und/oder Modbus-Teilnehmers.

Eine weitere vorteilhafte Ausgestaltung des Busteilnehmers sieht vor, dass der Konfigurationsschalter ferner derartig ausgebildet ist, dass zumindest die zum Einstellen der spezifischen Konfiguration ausgewählte RC-Kombination zur Selbstschwingung angeregt wird. Insbesondere sieht die Ausgestaltung vor, dass die charakteristische Größe zumindest eine Frequenz der zum Einstellen der spezifischen Konfiguration ausgewählten selbstschwingenden RC-Kombination umfasst, so dass die einzustellende spezifische Konfiguration über die Frequenz des Ausganssignals bestimmbar ist und/oder dass der Konfigurationsschalter ferner derartig ausgebildet ist, dass jede RC-Kombination jeweils einen voneinander unterschiedlichen Tastgrad aufweist, so dass die charakteristische Größe zusätzlich einen Tastgrad der zum Einstellen der spezifischen Konfiguration ausgewählten selbstschwingenden RC-Kombination umfasst, so dass die einzustellende spezifische Konfiguration ferner über den Tastgrad bestimmbar ist.

Wiederum eine weitere vorteilhafte Ausgestaltung des Busteilnehmers sieht vor, dass die Vielzahl von einstellbaren jeweils unterschiedlichen RC-Kombinationen durch die Reihenschaltung einer Kapazität zu einer Parallelschaltung mit einer Vielzahl von parallelen Schaltungszweigen, die jeweils zumindest einen voneinander unterschiedlichen Widerstand und einen in Serie dazu geschalteten Schalter umfassen, realisiert sind, und der Konfigurationsschalter ferner derartig ausgebildet ist, dass durch das Betätigen zumindest eines spezifischen Schalters der in Serie zu den Widerständen geschalteten Schaltern die spezifische RC-Kombination auswählbar ist. Insbesondere kann die Ausgestaltung ferner einen Pull-up-Widerstand, ein Schaltelement, insbesondere einen Transistor, und ein Komparator, insbesondere ein Schmitt-Trigger, mit einer ersten und einer davon unterschiedlichen zweiten Schaltschwelle, umfassen, wobei der Pull-up-Widerstand in Serie mit der Kapazität und der Parallelschaltung zu einer Versorgungsspannung und der Komparator parallel zur Parallelschaltung geschaltet ist, wobei das Schaltelement derartig angeordnet und durch den Komparator steuerbar ist, dass die Kapazität über den Widerstand der spezifisch ausgewählten RC-Kombination und dem Pull-up-Widerstand bis zum Erreichen der ersten Schaltschwelle ladbar ist und nur über den Widerstand der spezifisch ausgewählten RC-Kombination und nicht den Pull-up-Widerstand bis zum Erreichen der zweiten Schaltschwelle entladbar ist.

Eine alternative Ausgestaltung hierzu sieht vor, dass der Konfigurationsschalter derartig ausgebildet ist, dass in dem Fall, dass das Ausgangssignal an dem Ausgang auf einen Low-Pegel gezogen wird, sich die Kapazität entlädt und in dem Fall, dass das Ausgangssignal an dem Ausgang auf ein High-Z, d.h. hochohmig, geschaltet wird, sich die Kapazität in Abhängigkeit der spezifisch ausgewählten RC-Kombination gemäß einer spezifischen Zeitkonstante auflädt, wobei die charakteristische Größe die spezifische Zeitkonstante der spezifisch ausgewählten RC-Kombination umfasst, so dass über das Ausgangssignal an dem Ausgang des Konfigurationsschalters die einzustellende spezifische Konfiguration anhand der spezifischen Zeitkonstante festgelegt ist.

Eine vorteilhafte Ausgestaltung des Busteilnehmer umfasst ferner eine Recheneinheit, insbesondere einen Mikroprozessor, der über einen, vorzugsweise einen einzigen Pin mit dem Ausgang des Konfigurationsschalters verbunden ist, so dass der Recheneinheit das Ausgangssignal, welches die charakteristische Größe aufweist, zugeführt ist, wobei die Recheneinheit dazu eingerichtet ist, anhand der charakteristischen Größe die einzustellenden spezifische Konfiguration zu ermitteln.

Eine vorteilhafte Ausgestaltung des Busteilnehmer sieht vor, dass die Recheneinheit das Ausgangssignal an dem Ausgang auf einen Low-Pegel zieht, so dass sich die Kapazität entlädt und das Ausgangssignal an dem Ausgang auf einen High-Pegel zieht, so dass sich die Kapazität in Abhängigkeit der spezifisch ausgewählten RC-Kombination gemäß der spezifischen Zeitkonstante auflädt, wobei die Recheneinheit ferner dazu eingerichtet ist, anhand der spezifischen Zeitkonstante als charakteristische Größe die einzustellenden spezifische Konfiguration ermittelt.

Eine weitere vorteilhafte Ausgestaltung des Busteilnehmers sieht vor, dass die Recheneinheit dazu ausgelegt ist, die charakteristische Größe über einen Schmitt-Trigger-Eingang oder durch einen Analog-Digital-Konverter-Eingang zu ermitteln.

Die Erfindung wird anhand der nachfolgenden Zeichnungen näher erläutert. Es zeigt:
Fig. 1: eine schematische Darstellung eines ersten Ausführungsbeispiels eines erfindungsgemäßen Konfigurationsschalters, und
Fig. 2: eine schematische Darstellung eines zweiten, alternativen Ausführungsbeispiels des erfindungsgemäßen Konfigurationsschalters.

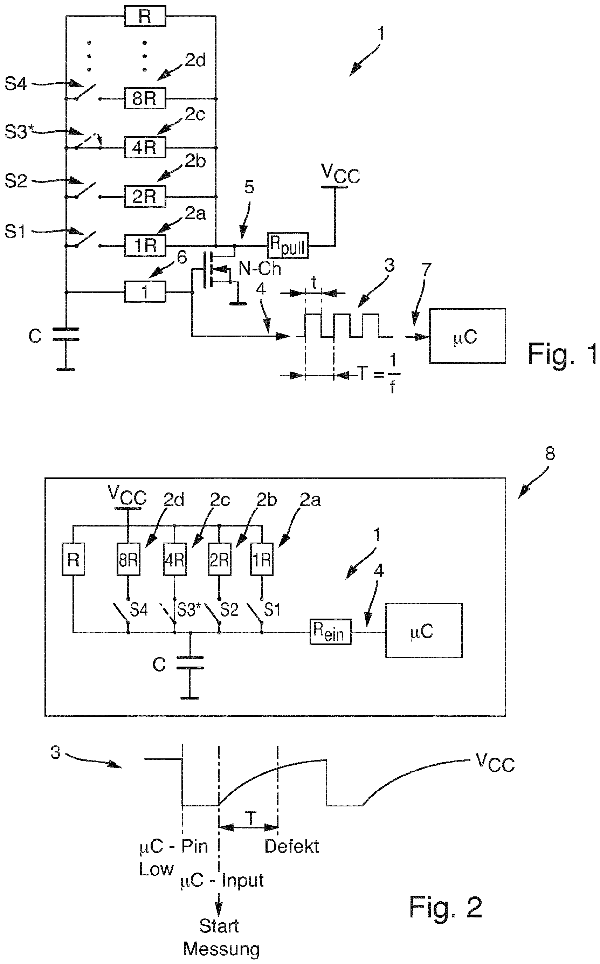

Figur 1 zeigt eine schematische Darstellung eines ersten Ausführungsbeispiels des erfindungsgemäßen Konfigurationsschalters 1. Der Konfigurationsschalter 1 umfasst eine Vielzahl von unterschiedlichen RC-Kombinationen 2a, 2b, 2c und 2d, wobei jede RC-Kombination 2a, 2b, 2c und 2d dieselbe Kapazität C, bspw. in Form eines Kondensators, und jeweils unterschiedliche parallel zueinander verschaltet Widerstände 1R, 2R, 4R und 8R aufweist. Ferner umfasst der Konfigurationsschalter 1 Schalter S1, S2, S3 und S4 zum Einstellen einer spezifischen Konfiguration durch einen Bediener, wobei die Schalter S1, S2, S3 und S4 jeweils in Reihe zu den jeweiligen Widerständen 1R, 2R, 4R und 8R geschaltet sind.

Beim ersten Ausführungsbeispiel wird eine Frequenz als charakteristische Größe den jeweiligen RC-Kombinationen zugeordnet, so dass die Auswahl einer spezifischen RC-Kombination und somit einer spezifisch eingestellten Konfiguration anhand der Frequenz eines (einzigen) Ausgangssignals an einem (einzigen) Ausgang bzw. einem (einzigen) Ausgangspin 4 des Konfigurationsschalters 1 bestimmbar ist. Um jeder RC-Kombination eine eindeutige und voneinander unterschiedliche Frequenz als charakteristische Größe zuordnen zu können ist der Konfigurationsschalter 1 als selbstschwingender Oszillator ausgebildet, dessen Schwingfrequenz durch das zu- und wegschalten von Widerständen mittels der Schalter S1, S2, S3 und S4 beeinflussbar ist. Hierzu weist der Konfigurationsschalter 1 in dem in Fig. 1 dargestellten Ausführungsbeispiel eine Schmitt-Trigger Komponente 6 auf, die derartig verschaltet ist, dass die Kapazität C bis zu einer oberen Schaltschwelle über einen weiteren Widerstand R, welcher parallel zu den RC-Kombinationen 2a, 2b, 2c und 2d verschaltet ist, geladen und anschließend bis zu einer unteren Schaltschwelle über die spezifisch ausgewählte RC-Kombination (in Fig. 1: 2c) wieder entladen wird, so dass das Ausgangssignal am Ausgang die spezifische charakteristische Größe in Form der für die ausgewählte RC-Kombination zutreffenden Frequenz, aufweist.

In dem in Fig. 1 dargestellten Ausführungsbeispiel ist exemplarisch der Schalter S3 als geschlossen dargestellt worden, so dass das Ausgangssignal die für die ausgewählte RC-Kombination (in dem dargestellten Beispiel die 4RC-Kombination) entsprechende Frequenz aufweist. In einer bevorzugten Ausgestaltung weisen die Widerstände der RC-Kombinationen eine dem Dualsystem entsprechende Wertigkeit auf, bspw. 1 kOhm, 2kOhm, 4kOhm, 8kOhm, etc..

Ebenfalls kann im ersten Ausführungsbeispiel der Konfigurationsschalter einen N-Kanal-MOSFET 5 und einen Pullup-Widerstand R_{Pull} aufweisen, wobei das Gate des MOSFET 5 mit einem Ausgang des Schmitt-Triggers, der Source des MOSFET 5 mit Masse und der Drain über den Pullup-Widerstand R_{Pull} mit einer Versorgungsspannung VCC verbunden ist. Durch den MOSFET 5 und den Pullup-Widerstand R_{Pull} kann zusätzlich zu der Frequenz noch ein Dutycycle bzw. der Tastgrad (definiert als τ/T mit τ = Impulsdauer und T = Periodendauer) beeinflusst werden, da das Entladen des Kondensators nur über die Widerstände 1R, 2R, 4R und 8R, jedoch das Laden inklusive des Pullup-Widerstandes R_{Pull} an der Versorgungsspannung VCC erfolgt.

Alternativ zu der Frequenz und ggfl. der Dutycycle als charakteristische Größe kann der Konfigurationsschalter 1 aber auch derartig ausgebildet sein, dass eine spezifische Zeitkonstante, insbesondere eine Ladezeitkonstante, als charakteristische Größe verwendet wird. Fig.2 zeigt hierfür exemplarisch ein zweites Ausführungsbeispiel. Gemäß diesem Ausführungsbeispiel weist der Konfigurationsschalter 1 ebenfalls eine Vielzahl von unterschiedlichen RC-Kombinationen 2a, 2b, 2c und 2d, wobei jede RC-Kombination 2a, 2b, 2c und 2d dieselbe Kapazität C, bspw. in Form eines Kondensators, und jeweils unterschiedliche parallel zueinander verschaltet Widerstände 1R, 2R, 4R und 8R auf. Ferner umfasst der Konfigurationsschalter 1 ebenfalls Schalter S1, S2, S3 und S4 zum Einstellen einer spezifischen Konfiguration anhand der Vielzahl von unterschiedlichen RC-Kombinationen 2a, 2b, 2c und 2d durch einen Bediener, wobei die Schalter S1, S2, S3 und S4 in Reihe zu den jeweiligen Widerständen 1R, 2R, 4R und 8R geschaltet sind. Ferner weist der Konfigurationsschalter 1 ebenfalls einen Widerstand R auf, welcher parallel zu den parallel versschalteten Widerständen 1R, 2R, 4R und 8R mit den jeweiligen Schaltern S1, S2, S3 und S4 geschaltet ist. Der Konfigurationsschalter ist mit seinem Ausgang bzw. Ausgangspin über einen Widerstand R_{Ein} an eine Recheneinheit µC, bspw. einen Mikroprozessor, angeschlossen. Die Recheneinheit µC ist derartig eingerichtet, dass ein Eingangspin an dem der Konfigurationsschalter 1 mit seinem Ausgangspin 4 angeschlossen ist, auf "Low", d.h. niederohmig schaltbar ist, um die Kapazität C des Konfigurationsschalters 1 zu entladen und anschließend auf "High Z", d.h. hochohmig, schaltbar ist, um die Kapazität C des Konfigurationsschalters 1 zu laden. Das Schalten auf "High-Z" durch die Recheneinheit µC kann bspw. dadurch erreicht werden, dass der Ausgang bzw. Ausgangspin 4 des Konfigurationsschalters auf einen Eingangspin bzw. Input der Recheneinheit µC durch diese geschaltet wird. Durch die durch Schalter S1, S2, S3 und S4 ausgewählte RC-Kombination wird die Zeitkonstante bzw. Ladezeit beeinflusst und die Recheneinheit µC kann eine entsprechende spezifische Konfiguration anhand der Zeitkonstante als charakteristische Größe ermitteln.

Das Ermitteln der Zeitkonstante als charakteristische Größe kann über ein Gatter erfolgen, welches beim Erreichen einer oberen Schaltschwelle ("High") umschaltet, so dass die Zeitkonstante ermittelbar ist. Das Gatter kann sowohl durch eine externe, d.h. eine außerhalb der Recheneinheit ausgebildete, Komponente als auch durch eine interne, d.h. eine innerhalb der Recheneinheit abgebildeten, Komponente realisiert sein. Beispielsweise kann ein Schmitt-Trigger-Eingang oder auch ein Analog-Digital-Converter-Eingang (ADC) der Recheneinheit µC dazu verwendet werden. Der in Fig. 2 dargestellte Signalverlauf verdeutlicht, dies exemplarisch, in dem zuerst der Ausgang des Konfigurationsschalters auf ein Low-Pegel durch die Recheneinheit µC gezogen wird, um die Kapazität zu entladen und anschließend der Ausgang High-Z geschaltet wird, bspw. dadurch, dass die Recheneinheit den Ausgang des Konfigurationsschalters intern auf einen Input legt, so dass sich die Kapazität laden kann. Anschließend kann das Ladeverhalten und somit die Zeitkonstante wie oben beschrieben ermittelt werden.

Der in Fig. 1 und Fig. 2 dargestellte Konfigurationsschalter kann zusammen mit der Recheneinheit µC in einen Busteilnehmer 8, bspw. einen Profibus- oder Modbus-Teilnehmer, integriert werden. In dem Busteilnehmer 8 kann der Konfigurationsschalter 1 bspw. dazu dienen, eine Slaveadresse des Busteilnehmers 8 einzustellen. Hierbei können in den vorliegenden Ausführungsbeispielen jeweils 128 (= 2^7) unterschiedliche Adressen durch entsprechende Betätigung der Schalter S1, S2, S3 und S4 eingestellt werden.

Exemplarisch ist sowohl in dem ersten als auch dem zweiten Ausführungsbeispiel der Schalter S3 als spezifisch betätigt dargestellt (mit einem Stern markiert), so dass entweder die für die RC-Kombination mit dem 4R Widerstand sich ergebende spezifische Frequenz (und ggfl. auch dessen Dutycycle) oder die spezifische Zeitkonstante als charakteristische Größe dient, welche von der Recheneinheit µC entsprechend ermittelt und einer spezifischen Konfiguration, bspw. eine spezifischen Slaveadresse, zugeordnet wird.

### Bezugszeichenliste

- 1: Konfigurationsschalter
- 2a, 2b, 2c, 2d: RC-Kombinationen
- 3: Ausgangssignal
- 4: Ausgang bzw. Ausgangspin
- 5: Schaltelement
- 6: Komparator, insb. Schmitt-Trigger
- 7: einzelner Pin des Mikroprozessors
- 8: Busteilnehmer, insb. Profibus-Teilnehmer
- 1R, 2R, 4R, 8R: Widerstände mit einem Widerstandswert von R, 2R, 4R, 8R
- C: Kapazität
- R_{Pull}: Pull-up-Widerstand
- µC: Recheneinheit bzw. Mikroprozessor

## Patentansprüche

1. Busteilnehmer, insbesondere einen Profibus-Teilnehmer, umfassend einen Konfigurationsschalter (1) zur Einstellung einer spezifischen Konfiguration des Busteilnehmers aus einer Vielzahl von einstellbaren Konfigurationen, wobei der Konfigurationsschalter (1) zumindest eine Vielzahl von auswählbaren jeweils unterschiedlichen RC-Kombinationen (2a, 2b, 2c, 2d) aufweist, wobei jede der RC-Kombinationen (2a, 2b, 2c, 2d) zumindest eine spezifische charakteristische Größe aufweist, die einer der einstellbaren Konfigurationen zugeordnet ist und wobei zum Einstellen der spezifischen Konfiguration eine spezifische RC-Kombination (2c) aus der Vielzahl von den RC-Kombinationen auswählbar ist, so dass über ein Ausgangssignal (3) an einem Ausgang (4) des Konfigurationsschalters (1), welches Ausgangssignal (3) die spezifische charakteristische Größe der ausgewählten RC-Kombination (2c) umfasst, die einzustellende spezifische Konfiguration anhand der spezifischen charakteristischen Größe festgelegt ist.

2. Busteilnehmer nach Anspruch 1, wobei die einzustellende spezifische Konfiguration und/oder die Vielzahl von einstellbaren Konfigurationen eine Adresse eines Busteilnehmers umfassen, insbesondere eine Slaveadresse eines Profibus- und/oder Modbus-Teilnehmers.

3. Busteilnehmer nach Anspruch 1 oder 2, wobei der Konfigurationsschalter (1) ferner derartig ausgebildet ist, dass zumindest die zum Einstellen der spezifischen Konfiguration ausgewählte RC-Kombination (2c) zur Selbstschwingung angeregt wird, wobei der Konfigurationsschalter hierzu eine Schmitt-Trigger Komponente (6) aufweist, die derartig verschaltet ist, dass eine Kapazität (C) bis zu einer oberen Schaltschwelle über einen weiteren Widerstand (R), welcher parallel zu den RC-Kombinationen (2a, 2b, 2c, 2d) verschaltet ist, geladen und anschließend bis zu einer unteren Schaltschwelle über die spezifisch ausgewählte RC-Kombination (2c) wieder entladen wird, so dass das Ausgangssignal am Ausgang die spezifische charakteristische Größe in Form der für die ausgewählte RC-Kombination (2c) zutreffenden Frequenz, aufweist.

4. Busteilnehmer nach dem Anspruch 3, wobei der Konfigurationsschalter (1) ferner derartig ausgebildet ist, dass jede der RC-Kombinationen (2a, 2b, 2c, 2d) jeweils einen voneinander unterschiedlichen Tastgrad (τ/T) aufweist, so dass die charakteristische Größe zusätzlich einen Tastgrad (τ/T), der zum Einstellen der spezifischen Konfiguration ausgewählten selbstschwingenden RC-Kombination (2c) umfasst, so dass die einzustellende spezifische Konfiguration ferner über den Tastgrad (τ/T) bestimmbar ist.

5. Busteilnehmer nach zumindest einem der vorhergehenden Ansprüche, wobei die Vielzahl von einstellbaren jeweils unterschiedlichen RC-Kombinationen (2a, 2b, 2c, 2d) durch die Reihenschaltung einer Kapazität (C) zu einer Parallelschaltung mit einer Vielzahl von parallelen Schaltungszweigen, die jeweils zumindest einen voneinander unterschiedlichen Widerstand (1R, 2R, 4R, 8R) und einen in Serie dazu geschalteten Schalter (S1, S2, S3, S4) umfassen, realisiert sind, und der Konfigurationsschalter (1) ferner derartig ausgebildet ist, dass durch das Betätigen zumindest eines spezifischen Schalters (S3*) die spezifische RC-Kombination (2c) auswählbar ist.

6. Busteilnehmer nach dem vorhergehenden Anspruch, wobei der Konfigurationsschalter ferner einen Pull-up-Widerstand (R_{Pull}), ein Schaltelement (5), insbesondere einen Transistor, und ein Komparator (6), insbesondere ein Schmitt-Trigger, mit einer ersten und einer davon unterschiedlichen zweiten Schaltschwelle, umfasst, wobei der Pull-up-Widerstand(R_{Pull}) in Serie mit der Kapazität (C) und der Parallelschaltung zu einer Versorgungsspannung (Vcc) und der Komparator (6) parallel zur Parallelschaltung geschaltet ist, wobei das Schaltelement (5) derartig angeordnet und durch den Komparator (6) steuerbar ist, dass die Kapazität (C) über den Widerstand (4R) der spezifisch ausgewählten RC-Kombination (2c) und dem Pull-up-Widerstand (R_{Pull}) bis zum Erreichen der ersten Schaltschwelle ladbar ist und nur über den Widerstand (4R) der spezifisch ausgewählten RC-Kombination (2c) und nicht den Pull-up-Widerstand (R_{Pull}) bis zum Erreichen der zweiten Schaltschwelle entladbar ist.

7. Busteilnehmer nach Anspruch 1 und/oder 2, wobei der Konfigurationsschalter ferner derartig ausgebildet ist, dass in dem Fall, dass das Ausgangssignal (3) an dem Ausgang (4) auf einen Low-Pegel gezogen wird, sich die Kapazität (C) entlädt und in dem Fall, dass das Ausgangssignal (3) an dem Ausgang (4) auf ein High-Z geschaltet wird, sich die Kapazität (C) in Abhängigkeit der spezifisch ausgewählten RC-Kombination (2c) gemäß einer spezifischen Zeitkonstante (T) auflädt, wobei die charakteristische Größe die spezifische Zeitkonstante (T) der spezifisch ausgewählten RC-Kombination (2c) umfasst, so dass über das Ausgangssignal (3) an dem Ausgang (4) des Konfigurationsschalters (1) die einzustellende spezifische Konfiguration anhand der spezifischen Zeitkonstante festgelegt ist.

8. Busteilnehmer nach Anspruch 1, ferner umfassend eine Recheneinheit (µC), insbesondere einen Mikroprozessor, der über einen, vorzugsweise einen einzigen Pin (7) mit dem Ausgang (4) des Konfigurationsschalters (1) verbunden ist, so dass der Recheneinheit (µC) das Ausgangssignal (3), welches die charakteristische Größe aufweist, zugeführt ist, wobei die Recheneinheit (µC) dazu eingerichtet ist, anhand der charakteristischen Größe die einzustellenden spezifische Konfiguration zu ermitteln.

9. Busteilnehmer nach dem vorhergehenden Anspruch, wobei die Recheneinheit das Ausgangssignal (3) an dem Ausgang (4) auf einen Low-Pegel zieht, so dass sich die Kapazität (C) entlädt und nach dem Entladen das Ausgangssignal (3) an dem Ausgang (4) auf ein High-Z schaltet, so dass sich die Kapazität (C) in Abhängigkeit der spezifisch ausgewählten RC-Kombination (2c) gemäß der spezifischen Zeitkonstante (T) auflädt, wobei die Recheneinheit (µC) ferner dazu eingerichtet ist, anhand der spezifischen Zeitkonstante (T) als charakteristische Größe die einzustellenden spezifische Konfiguration ermittelt.

10. Busteilnehmer nach einem der Ansprüche 8 oder 9, wobei die Recheneinheit dazu ausgelegt ist, die charakteristische Größe über einen Schmitt-Trigger-Eingang oder durch einen Analog-Digital-Konverter-Eingang zu ermitteln.

## Claims

1. Bus user, particularly a Profibus user, comprising a configuration switch (1) to set a specific configuration of the bus user from multiple configurations that can be set, wherein the configuration switch (1) has at least multiple different RC combinations (2a, 2b, 2c, 2d) that can be selected, wherein each RC combination (2a, 2b, 2c, 2d) has at least a specific characteristic variable that is assigned to one of the configurations that can be set and wherein, to set the specific configuration, a specific RC combination (2c) can be selected from the multiple RC combinations, in such a way that the specific configuration to be set is determined using the specific characteristic variable via an output signal (3) at an output (4) of the configuration switch (1), wherein said output signal (3) comprises the specific characteristic variable of the selected RC combination (2c).

2. Bus user as claimed in Claim 1, wherein the specific configuration to be set and/or the multiple configurations that can be set comprise an address of a bus user, particularly a slave address of a Profibus user and/or Modbus user.

3. Bus user as claimed in Claim 1 or 2, wherein the configuration switch (1) is further designed in such a way that at least the RC combination (2c) selected to set the specific configuration is excited to self-oscillate, wherein the configuration switch has a Schmitt trigger component (6) for this which is switched in such a way that a capacitance (C) is charged up to an upper switching threshold via another resistor (R) that is switched in parallel with the RC combinations (2a, 2b, 2c, 2d), and is then discharged down as far as a lower switching threshold via the specifically selected RC combination (2c) such that, at the output, the output signal has the specific characteristic variable in the form of the appropriate frequency for the selected RC combination (2c).

4. Bus user as claimed in Claim 3, wherein the configuration switch (1) is further designed in such a way that each of the RC combinations (2a, 2b, 2c, 2d) has a duty cycle (τ/T) that is different from the other combinations such that the characteristic variable further comprises a duty cycle (τ/T) of the self-oscillating RC combination (2c) selected to set the specific configuration, such that the specific configuration to be set can further be determined via the duty cycle (τ/T).

5. Bus user as claimed in at least one of the previous claims, wherein the multiple different configurable RC combinations (2a, 2b, 2c, 2d) are implemented by the series circuiting of a capacitance (C) to a parallel circuit with multiple parallel circuit branches, wherein each comprise at least one resistor (1R, 2R, 4R, 8R) which differs from the others and a switch (S1, S2, S3, S4) connected in series, and wherein the configuration switch (1) is further designed in such a way that the specific RC combination (2c) can be selected by pressing at least a specific switch (S3*).

6. Bus user as claimed in the previous claim, wherein the configuration switch further comprises a pull-up resistor (R_{Pull}), a switch element (5), particularly a transistor, and a comparator (6), particularly a Schmitt trigger, with a first switching threshold and a second switching threshold different to the first, wherein the pull-up resistor (R_{Pull}) is connected in series with the capacitance (C) and the parallel circuit to a supply voltage (Vcc) and the comparator (6) is connected in parallel to the parallel circuit, wherein the switch element (5) is arranged and can be controlled by the comparator (6) in such a way that the capacitance (C) can be charged by means of the resistor (4R) of the specifically selected RC combination (2c) and the pull-up resistor (R_{Pull}) until the first switching threshold is reached and can only be discharged by means of the resistor (4R) of the specifically selected RC combination (2c) and not by means of the pull-up resistor (R_{Pull}) until the second switching threshold is reached.

7. Bus user as claimed in Claim 1 and/or 2, wherein the configuration switch is further designed in such a way that, in the event that the output signal (3) is pulled down to a low level at the output (4), the capacitance (C) is discharged, and in the event that the output signal (3) is switched to a high Z at the output (4), the capacitance (C) is charged depending on the specifically selected RC combination (2c) according to a specific time constant (T), wherein the characteristic variable comprises the specific time constant (T) of the specifically selected RC combination (2c) such that the specific configuration to be set is determined using the specific time constant via the output signal (3) at the output (4) of the configuration switch (1).

8. Bus user as claimed in Claim 1, further comprising a computing unit (µC), particularly a microprocessor, wherein said unit is connected to the output (4) of the configuration switch (1) by means of a, preferably single, pin (7), such that the output signal (3) that has the characteristic variable is fed to the computing unit (µC), wherein the computing unit (µC) is designed to determine the specific configuration to be set using the characteristic variable.

9. Bus user as claimed in the previous claim, wherein the computing unit pulls the output signal (3) at the output (4) to a low level, such that the capacitance (C) is discharged and, following the discharge, the output signal (3) at the output (4) switches to a high-Z such that the capacitance (C) is charged depending on the specifically selected RC combination (2c) according to the specific time constant (T), wherein the computing unit (µC) is further designed to determine the specific configuration to be set using the specific time constant (T) as a characteristic variable.

10. Bus user as claimed in one of the Claims 8 or 9, wherein the computing unit is designed to determine the characteristic variable via a Schmitt trigger input or by means of an analog/digital converter input.

## Revendications

1. Utilisateur de bus, notamment un utilisateur Profibus, comprenant un commutateur de configuration (1) pour le réglage d'une configuration spécifique de l'utilisateur de bus parmi une pluralité de configurations réglables, le commutateur de configuration (1) présentant au moins une pluralité de combinaisons RC (2a, 2b, 2c, 2d) respectivement différentes pouvant être sélectionnées, chacune des combinaisons RC (2a, 2b, 2c, 2d) présentant au moins une grandeur caractéristique spécifique, qui est associée à l'une des configurations réglables et où, pour le réglage de la configuration spécifique, une combinaison RC spécifique (2c) pouvant être sélectionnée parmi la pluralité des combinaisons RC, de sorte que, par l'intermédiaire d'un signal de sortie (3) à une sortie (4) du commutateur de configuration (1), lequel signal de sortie (3) comprend la grandeur caractéristique spécifique de la combinaison RC sélectionnée (2c), la configuration spécifique à régler est déterminée à l'aide de la grandeur caractéristique spécifique.

2. Utilisateur de bus selon la revendication 1, pour lequel la configuration spécifique à régler et/ou la pluralité de configurations réglables comprennent une adresse d'un utilisateur de bus, notamment une adresse esclave d'un utilisateur Profibus et/ou Modbus.

3. Utilisateur de bus selon la revendication 1 ou 2, pour lequel le commutateur de configuration (1) est en outre conçu de telle sorte qu'au moins la combinaison RC (2c) sélectionnée pour le réglage de la configuration spécifique est excitée pour l'auto-oscillation, le commutateur de configuration présentant à cet effet un composant à trigger de Schmitt (6), lequel composant est couplé de telle sorte qu'une capacité (C) est chargée jusqu'à un seuil de commutation supérieur par une autre résistance (R), laquelle résistance est couplée en parallèle avec les combinaisons RC (2a, 2b, 2c, 2d), et est ensuite à nouveau déchargée jusqu'à un seuil de commutation inférieur par l'intermédiaire de la combinaison RC (2c) spécifiquement sélectionnée, de sorte que le signal de sortie présente à la sortie la grandeur caractéristique spécifique sous la forme de la fréquence correspondant à la combinaison RC (2c) sélectionnée.

4. Utilisateur de bus selon la revendication 3, pour lequel le commutateur de configuration (1) est en outre conçu de telle sorte que chacune des combinaisons RC (2a, 2b, 2c, 2d) présente respectivement un cycle de service (τ/T) différent l'un de l'autre, de sorte que la grandeur caractéristique comprend en outre un cycle de service (τ/T) de la combinaison RC auto-oscillante (2c) sélectionnée pour régler la configuration spécifique, de sorte que la configuration spécifique à régler peut en outre être déterminée par le cycle de service (τ/T).

5. Utilisateur de bus selon l'une des revendications précédentes, pour lequel la pluralité de combinaisons RC (2a, 2b, 2c, 2d) respectivement différentes et réglables est réalisée par le montage en série d'une capacité (C) à un montage en parallèle comprenant une pluralité de branches de circuit parallèles, qui comprennent chacune au moins une résistance (1R, 2R, 4R, 8R) différente les unes des autres et un commutateur (S1, S2, S3, S4) monté en série avec elle, et le commutateur de configuration (1) est en outre conçu de telle sorte que la combinaison RC spécifique (2c) peut être sélectionnée par l'actionnement d'au moins un commutateur spécifique (S3*).

6. Utilisateur de bus selon la revendication précédente, pour lequel le commutateur de configuration comprend en outre une résistance de pull-up (R_{Pull}), un élément de commutation (5), notamment un transistor, et un comparateur (6), notamment un trigger de Schmitt, avec un premier seuil de commutation et un deuxième seuil de commutation différent du premier, la résistance de pull-up (R_{Pull}) étant couplée en série avec la capacité (C) et le circuit parallèle à une tension d'alimentation (Vcc) et le comparateur (6) étant couplé en parallèle au circuit parallèle, l'élément de commutation (5) étant disposé et pouvant être commandé par le comparateur (6) de telle sorte que la capacité (C) puisse être chargée par l'intermédiaire de la résistance (4R) de la combinaison RC spécifiquement sélectionnée (2c) et de la résistance de pull-up (R_{Pull}) jusqu'à atteindre le premier seuil de commutation et puisse être déchargée uniquement par l'intermédiaire de la résistance (4R) de la combinaison RC spécifiquement sélectionnée (2c) et non de la résistance de pull-up (R_{Pull}) jusqu'à atteindre le deuxième seuil de commutation.

7. Utilisateur de bus selon la revendication 1 et/ou 2, pour lequel le commutateur de configuration est en outre conçu de telle sorte que, dans le cas où le signal de sortie (3) est tiré à un niveau bas à la sortie (4), la capacité (C) se décharge et, dans le cas où le signal de sortie (3) est commuté à un état haute impédance à la sortie (4), la capacité (C) se charge en fonction de la combinaison RC (2c) spécifiquement sélectionnée selon une constante de temps spécifique (T), la grandeur caractéristique comprenant la constante de temps spécifique (T) de la combinaison RC (2c) spécifiquement sélectionnée, de sorte que, par l'intermédiaire du signal de sortie (3) à la sortie (4) du commutateur de configuration (1), la configuration spécifique à régler est déterminée à l'aide de la constante de temps spécifique.

8. Utilisateur de bus selon la revendication 1, comprenant en outre une unité de calcul (µC), notamment un microprocesseur, laquelle unité est reliée à la sortie (4) du commutateur de configuration (1) par l'intermédiaire d'une, de préférence d'une seule broche (7), de sorte que le signal de sortie (3), qui présente la grandeur caractéristique, est amené à l'unité de calcul (µC), l'unité de calcul (µC) étant conçue pour déterminer la configuration spécifique à régler à l'aide de la grandeur caractéristique.

9. Utilisateur de bus selon la revendication précédente, pour lequel l'unité de calcul tire le signal de sortie (3) à la sortie (4) à un niveau bas, de sorte que la capacité (C) se décharge et, après la décharge, commute le signal de sortie (3) à la sortie (4) à un état de haute impédance, de sorte que la capacité (C) se charge en fonction de la combinaison RC (2c) spécifiquement sélectionnée selon la constante de temps spécifique (T), l'unité de calcul (µC) étant en outre conçue pour déterminer la configuration spécifique à régler à l'aide de la constante de temps spécifique (T) en tant que grandeur caractéristique.

10. Utilisateur de bus selon l'une des revendications 8 ou 9, pour lequel l'unité de calcul est conçue pour déterminer la grandeur caractéristique par l'intermédiaire d'une entrée de trigger de Schmitt ou par l'intermédiaire d'une entrée de convertisseur analogique-numérique.
